Europäisches Patentamt

(19) European Patent Office

Office européen des brevets

(11) Publication number : **0 434 434 A1**

(12) **EUROPEAN PATENT APPLICATION**

(21) Application number : 90314037.4

(22) Date of filing : 20.12.90

(51) Int. Cl.⁵ : **H01L 21/306, C23F 1/08**

(30) Priority : 20.12.89 GB 8928773

(43) Date of publication of application :
26.06.91 Bulletin 91/26

(84) Designated Contracting States :
AT BE CH DE DK ES FR GB GR IT LI LU NL SE

(71) Applicant : THORN EMI plc
4 Tenterden Street
London W1A 2AY (GB)

(72) Inventor : Etienne, Stephen David
29 Willowtree Lane
Hayes, Middlesex UB4 9BD (GB)
Inventor : Sibbald, Alastair
18 Horseguards Drive
Maidenhead, Berkshire SL6 1XL (GB)
Inventor : Tagg, Wendy Iris Elizabeth
2 Willowtree Close
Hayes, Middlesex UB4 9BD (GB)

(74) Representative : Sorenti, Gino et al
THORN EMI Patents Limited, Central
Research Laboratories, Dawley Road
Hayes, Middlesex UB3 1HH (GB)

(54) **Fountain etch system.**

(57) Apparatus for back etching a body of material, such as a silicon wafer 12, comprises a fountain head 6 supplied with etchant 2 through an inlet pipe 4. The etchant 2 is forced through apertures 10 in a perforated member 8 and into contact with a surface of the silicon wafer 12 to be etched. Various configurations of apertures 10 are envisaged for maintaining the wafer 12 centrally over the fountain head 3 and also for imparting rotary motion to the wafer 12 to provide uniformity of etch.
The aparatus enables the silicon wafer to be supported solely by the etchant during the etching process, such that the wafer is subjected to minimal trauma.

FIG. 1

EP 0 434 434 A1

# FOUNTAIN ETCH SYSTEM

This invention relates to a means of etching a body of material in a well-controlled manner which is well-suited to mass production processing, and such that the surface undergoing etching is subjected to minimal trauma. In particular, this invention relates to the processing of semiconductor materials.

Integrated-circuit manufacturing techniques are being employed for the fabrication of a variety of silicon microstructures. By the use of anisotropic and isotropic etching techniques, it is possible to form very precisely defined grooves, cavities, ridges, apertures and diaphragms in, or on, single crystal silicon wafers, such as those which are commonly used for conventional electronic device fabrication. In many applications, it is required that a device is formed on the upper surface of a silicon wafer, and then the silicon underneath the device is partially or fully removed by etching.

The silicon can be selectively back-etched by forming a patterned oxide layer on the back surface, which is intrinsically resistant to the etchant. Such devices which require use of back-etching techniques for their fabrication are very fragile, and are readily damaged by scratching, abrasion or stress.

The back-etching of silicon can be performed on individual wafers by several means. The prime difficulty lies in ensuring that the upper surface of the wafer does not become exposed to the etchant.

One method of protecting the upper surface of the silicon whilst the wafer is immersed in the etchant is to apply a protective coating to it, such as a thin film of polyimide, prior to immersion. This is generally not effective because the etchants usually manage to penetrate behind the coating, lifting it away from the substrate and allowing the etchant to destroy the underlying devices. A further complication arises when the protective coating itself must be removed after the etch process has been completed ; this process itself can cause considerable damage to the devices on the wafer surface, especially where the microstructures possess moving elements. If grease or wax is used as a protective layer, these materials are virtually impossible to remove completely and clearly, hence they leave a damaged, contaminated surface.

Another method for protecting the upper surface of the wafer during etching of the back surface is to clamp the wafer to a protective plate, using an 0-ring to seal the two together. This technique can be successful, but the edge of the wafer can be physically damaged by abrasion from the 0-ring and by the mechanical stress involved. Furthermore, the combined wafer/plate assembly is bulky to handle, and in addition, some etchants can still attack the rubber and penetrate the seal. A further drawback is that this technique is not well suited to mass production where batch sizes of 25 wafers are commonplace, and when it is preferable to process the wafers in each batch simultaneously.

By mechanically protecting the wafer surfaces, as above, the etchants can be applied to the back surface of the wafer by selective spray, but this again requires a great deal of careful manual involvement, and the spraying of the corrosive etchants is considerably hazardous. Uniformity of etching is difficult to control, and the continuous evaporation of the solvents causes changes in etchant concentration, and the precipitation of solids in some cases. This technique, therefore, is also not well-suited to the mass-production of back-etched silicon devices.

Japanese Patent Application 60231330 describes an apparatus to enable a semiconductor material to be processed uniformly, by directing a processing liquid towards the undersurface of a semiconductor material through a multiplicity of small bores as a number of liquid jets. The apparatus comprises a rotatable chuck which holds the semiconductor material to be processed by suction. However, this technique exposes the material to unnecessary stress and abrasion.

The present invention attempts to alleviate these disadvantages and provides both a method and an apparatus for putting this method into effect.

According to the present invention there is provided a method of etching a body of material comprising at least two major surfaces, a first major surface of which is to be etched, the method comprising directing a flow of etchant at the first major surface in a manner such that the body of material is supported solely by the flow of etchant and limiting lateral displacement of the body whilst enabling the body to move freely on said etchant.

Preferably, the flow of etchant is directed at the first major surface by forcing the etchant through a perforated member thereby to support the body of material by the etchant above the perforated member.

The present invention also provides apparatus for etching a body of material, the apparatus comprising a region for accommodating the body of material, fluid flow means for providing a flow of etchant directed at a surface of the body of material for causing the body to be supported solely by the flow of etchant, and limiting means for limiting lateral displacement of the body of material relative to the flow of etchant.

The fluid flow means may comprise a perforated member having a plurality of outlet holes for providing the flow of etchant for supporting the body of material.

Advantageously, the outlet holes are arranged about a drain aperture for providing a radial and inward flow of etchant for causing the body of material to self centre relative to the flow of etchant.

In a preferred embodiment the perforated member comprises a plurality of spiralling fluke surface patterns for providing a spiral and inward flow of etchant for causing rotation of the body of material. The limiting means may comprise a plurality of buffer members for engagement by the body of material.

The method and apparatus of the present invention are particularly advantageous in the etching of semiconductor materials, in particular, silicon wafers.

The invention will now be described, by way of example only, with reference to the accompanying drawings of which :

Figure 1 is a schenatic cross sectional view of an apparatus according to the invention ;

Figure 2 is a schematic plan view of a fluid flow production means ;

Figure 3 is a schematic plan view of a fluid flow production means having radial etchant flow ;

Figure 4 is a schematic plan view of a fluid flow production means having a spiralling etchant flow ;

Figure 5 shows a schematic plan view and a sectional view of a fluid flow production means with angled source-nozzles, and non-centralized drain apertures.

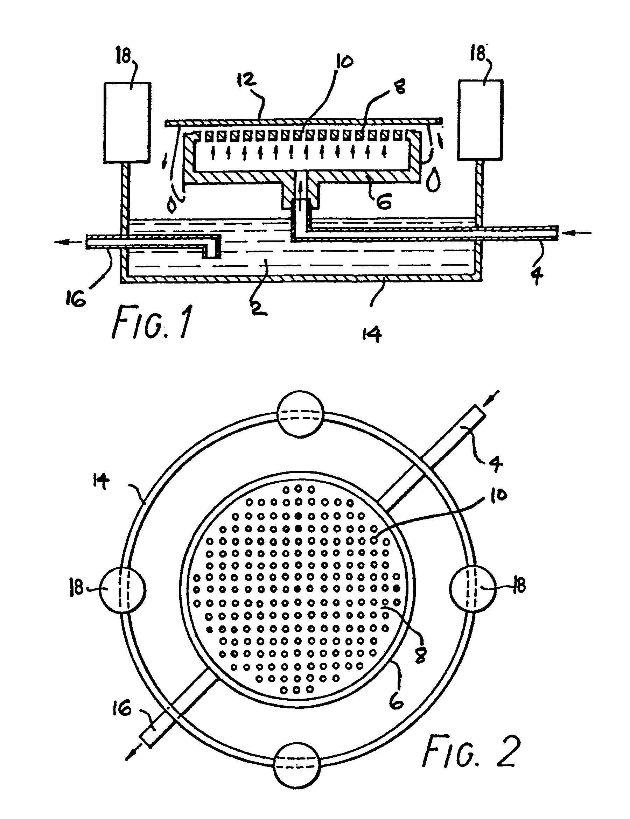

Figure 1 is a section of an apparatus in which back-etching of a body of material, for example a semiconductor material, such as a silicon wafer, can be achieved. The silicon wafer has a first major surface and a second major surface. A peristaltic pump is used to pump etchant 2 through an inlet pipe 4 and into the base of a fluid flow means which is in the form of a fountain head 6, including a perforated member 8, which in the embodiment shwon is in the form of a cirular disc. The etchant 2 is forced through outlet holes or perforations 10 and into contact with a major surface of a silicon wafer 12. The etchant 2 supports the silicon wafer 12 and flows outwards between the silicon wafer 12 and the perforated disc 8, and over edges of the fountain head 6, where it falls into a collecting container 14 and passes into the outlet pipe 16 for recirculation by the pump (now shown). The silicon wafer 12, is constrained to remain in-situ by limiting means which in the embodiment shown comprise mechanical buffers 18, two of which are illustrated in Figure 1.

Figure 2 shows a plan view of the system, where it can be seen that the apparatus is of general circular configuration to comply with the shape of the silicon wafer 12, which, generally, are circular in shape.

The silicon wafer may be located manually on the system using any suitable implement, such as a pair of tweezers, or, alternatively, using an automated placement apparatus as are commonly found in silicon wafer processing. The silicon wafer 12 may be removed during the etch process for intermittent inspection.

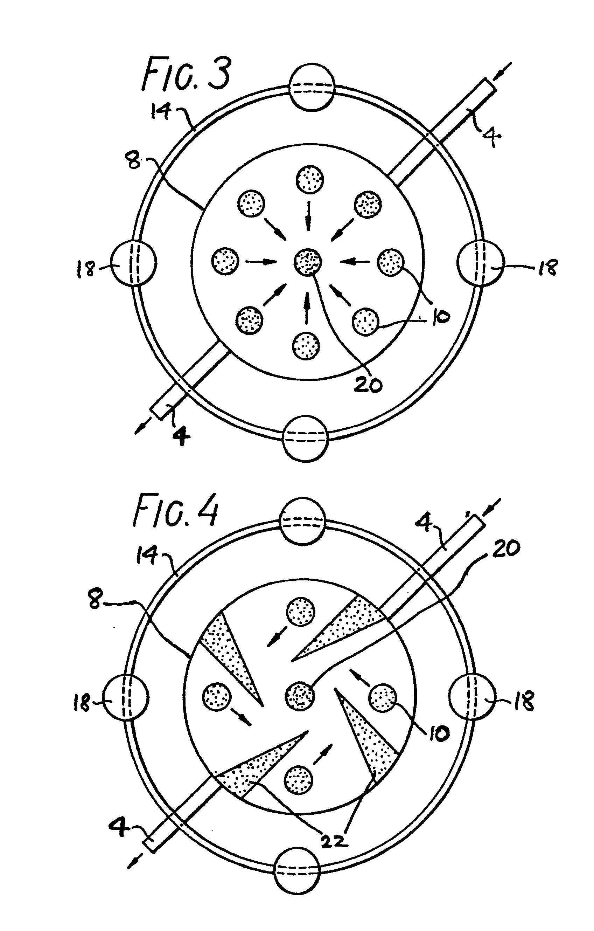

A variety of alternative fountain head configurations are also possible. For example, Figure 3 shows the plan view of a fountain head in which the outlet holes 10 are arranged in a circular configuration around a drain aperture 20. This arrangement causes the flow of etching fluid to occur radially and inwards under the wafer 12. Hence the net frictional force exerted by the etching fluid on the first major surface of the wafer 12 is always towards the centre of the fountain head 6, which causes the wafer be supported and to self-centre during etching by the radial flow of etching fluid.

Figure 4 shows an enhancement of this with the addition of several spiralling fluke patterns 22 embossed on the surface of the perforated member 8, which modify the radial etchant flux of the embodiment of Figure 3 into a spiral flux, causing the wafer to both self-centre and rotate on the supporting flow of etching fluid during the etching process, thereby improving the uniformity of the etch.

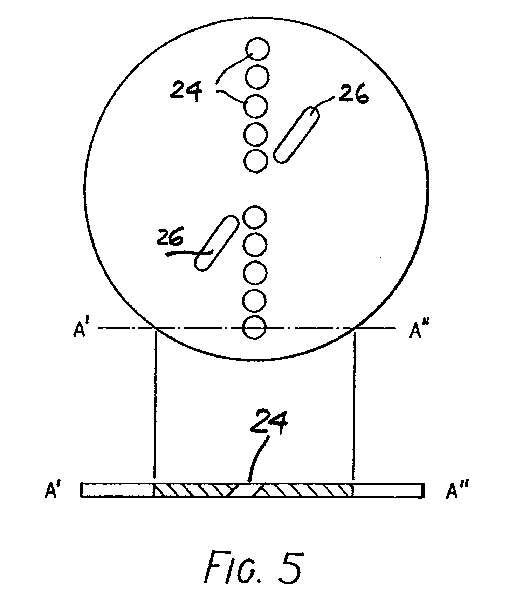

Figure 5 shows plan and sectional views of an alternative embodiment of fountain head wherein rotary motion of the wafer 12 can be induced by the formation of angled perforations 24 in the perforated member 8. It can be seen from Figure 5 that this embodiment also features non-centralized drain apertures 26 to minimise those areas of the wafer 12 which may not be contacted by the flow of etchant caused by the presence of the central drain aperture.

It can be seen that such a system provides a simple, easy to use, low-cost etching process which is well-suited to batch mass-production. It is, however, not limited solely to the processing of semiconductor wafers but may be applied to other bodies of material, for example lenses and prisms, which may be etched in a similar manner. Furthermore, although the present invention has been described with respect to specific embodiments it should be realised that modifications may be effected whilst remaining within the scope of the invention. For example, the apparatus is shown to be of generally circular configuration. However, other configurations are possible, dependent upon the shape of the body of material to be etched. Additionally, the fountain head in Figure 1 is shown being fed from a central aperture with the return of the etchant to the reservoir over the edges of the fountain head. The fountain head may also be fed with etchant through a number of inlet apertures.

Furthermore, other configurations of outlet holes 10, 24 and drainage apertures 20, 26 are also envisaged to provide appropriate flow patterns of etching fluid.

## Claims

1. A method of etching a body of material comprising at least two major surfaces, a first major surface of which is to be etched, the method comprising directing a flow of etchant at the first major surface in a manner such that the body of material is supported solely by the flow of etchant and limiting lateral displacement of the body whilst enabling the body to move freely on said etchant.

2. A method according to claim 1 wherein the flow of etchant is directed at the first major surface by forcing the etchant through a perforated member thereby to support the body of material by the etchant above the perforated member.

3. A method according to claim 2 wherein the perforated member comprises a plurality of outlet holes arranged about a drain aperture whereby the flow of etchant is arranged radially and inwardly for causing the body of material to self centre whilst supported by the flow of etchant.

4. A method according to claim 3 wherein the perforated member further comprises a plurality of spiralling fluke surface patterns whereby the flow of etchant is arranged to spiral inwardly for causing the body of material to rotate whilst supported by the flow of etchant.

5. A method according to claim 2 wherein the perforated member comprises a plurality of angled outlet holes and a plurality of drain apertures for imparting rotary motion to the body of material whilst supported by the flow of etchant.

6. Apparatus for etching a body of material, the apparatus comprising a region for accommodating the body of material, fluid flow means for providing a flow of etchant directed at a surface of the body of material for causing the body to be supported solely by the flow of etchant, and limiting means for limiting lateral displacement of the body of material relative to the flow of etchant.

7. Apparatus according to claim 6 wherein the fluid flow means comprises a perforated member having a plurality of outlet holes for providing the flow of etchant for supporting the body of material.

8. Apparatus according to claim 7 wherein the outlet holes are arranged about a drain aperature for providing a radial and inward flow of etchant for causing the body of material to self centre relative to the flow of etchant.

9. Apparatus according to claim 7 wherein the perforated member comprises a plurality of spiralling fluke surface patterns for providing a spiral and inward flow of etchant for causing rotation of the body of material.

10. Apparatus according to claim 7 wherein the perforated member includes a plurality of angles outlet holes for providing a flow of etchant arranged to impart rotary motion to the body of material and a plurality of drain apertures.

11. Apparatus according to any one of claims 6 to 10 wherein the limiting means comprises a plurality of buffer members for engagement by the body of material.

FIG. 1

FIG. 2

FIG. 3

FIG. 4

FIG. 5

European Patent
Office

## EUROPEAN SEARCH REPORT

Application Number

EP    90 31 4037

### DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | EP-A-130866 (FUJITSU LTD.) <br> * page 4, line 26 - page 6, line 26; claims 1, 2; figures 3A-4B * | 1, 2, 5-7, 10 | H01L21/306 <br> C23F1/08 |
| Y | | 3, 8 | |
| A | | 11 | |
| Y | PATENT ABSTRACTS OF JAPAN <br> vol. 9, no. 212 (E-339)(1935) 29 August 1985, <br> & JP-A-60 074438 (FUJITSU K.K.) 26 April 1985, <br> * the whole document * | 3, 8 | |
| A | | 1, 2, 5-7, 10 | |
| A | GB-A-1537924 (BUCKBEE-MEARS CO.) <br> * page 1, line 59 - page 2, line 75; claims 1-3, 5, 8; figures 1, 2 * | 1-3, 6-8 | |
| A | DE-A-3331816 (SIEMENS AG.) <br> * page 4, line 23 - page 5, line 35; claims 1, 2; figures 1, 2 * | 1, 2, 6, 7, 11 | |
| D,A | PATENT ABSTRACTS OF JAPAN <br> vol. 10, no. 87 (E-393) 05 April 1986, <br> & JP-A-60 231330 (SEIICHIROU SOUGOU) 16 November 1985, <br> * the whole document * | 1, 2, 6, 7 | **TECHNICAL FIELDS SEARCHED (Int. Cl.5 )** <br><br> H01L <br> C23F |
| A | US-A-4519846 (SEIICHIRO AIGO) <br> * column 3, lines 14 - 61; figure 2 * | 1, 2, 6, 7 | |
| A | EP-A-169541 (J.T. BAKER CHEMICAL CO.) <br> * page 12, line 1 - page 15, line 26; claims 2, 7-9B; figures 1, 6 * | 2-5, 7-10 | |

The present search report has been drawn up for all claims

| Place of search | Date of completion of the search | Examiner |
|---|---|---|
| BERLIN | 05 MARCH 1991 | KLOPFENSTEIN P. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

 

& : member of the same patent family, corresponding document

EPO FORM 1503 03.82 (P0401)